(19) Europäisches Patentamt
European Patent Office
Office européen des brevets

(11) Veröffentlichungsnummer: **0 186 626**
**B1**

(12) **EUROPÄISCHE PATENTSCHRIFT**

(45) Veröffentlichungstag der Patentschrift: **14.09.88**

(51) Int. Cl.⁴: **C 07 F 7/28**, C 07 F 17/00, G 03 C 1/68

(21) Anmeldenummer: **85810598.4**

(22) Anmeldetag: **16.12.85**

(54) **Titanocene und diese Titanocene enthaltende strahlungspolymerisierbare Zusammensetzung.**

(30) Priorität: **20.12.84 CH 6051/84**

(43) Veröffentlichungstag der Anmeldung: **02.07.86 Patentblatt 86/27**

(45) Bekanntmachung des Hinweises auf die Patenterteilung: **14.09.88 Patentblatt 88/37**

(84) Benannte Vertragsstaaten: **DE FR GB IT NL SE**

(56) Entgegenhaltungen: **EP - A - 0 122 223**

(73) Patentinhaber: **CIBA-GEIGY AG, Klybeckstrasse 141, CH-4002 Basel (CH)**

(72) Erfinder: **Riediker, Martin, Dr., Gstaltenrainweg 75, CH-4125 Riehen (CH)**
Erfinder: **Meier, Kurt. Dr., Ulmenstrasse 11, CH-4123 Allschwil (CH)**
Erfinder: **Zweifel, Hans, Dr., Leuengasse 4, CH-4057 Basel (CH)**

**EP 0 186 626 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die vorliegende Erfindung betrifft Metallocene mit mindestens einem eine Fluoralkylgruppe enthaltenden aromatischen Rest, eine fotopolymerisierbare Zusammensetzung aus äthylenisch ungesättigten Verbindungen, die diese Metallocene als Fotoinitiatoren enthält, ein mit dieser Zusammensetzung beschichtetes Substrat und ein Verfahren zur Herstellung fotografischer Reliefabbildungen unter Verwendung dieses beschichteten Substrates.

In der EP-A-0 122 223 sind Titanocene mit fluorsubstituierten aromatischen Resten beschrieben, die sich als Fotoinitiatoren zur Polymerisation äthylenisch ungesättigter Verbindungen eignen. Die Titanocene sind im aromatischen Rest durch mindestens ein Fluoratom in Orthostellung zur Metallkohlenstoffbindung substituiert, und sie müssen für ihre Wirksamkeit und thermische Beständigkeit zwei solche Reste enthalten.

Gegenstand vorliegender Erfindung sind Titanocene der Formel I

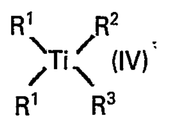

(I)

worin

beide $R^1$ unabhängig voneinander unsubstituiertes oder substituiertes Cyclopentadienyl$^{\ominus}$, Indenyl$^{\ominus}$, 4,5,6,7-Tetrahydroindenyl$^{\ominus}$ oder beide $R^1$ zusammen für einen unsubstituierten oder substituierten Rest der Formel II

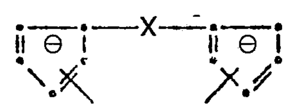

(II)

stehen, worin $X(-CH_2-)_n$ mit $n = 1$, 2 oder 3, Alkyliden mit 2 bis 12 C-Atomen, Cycloalkyliden mit 5 bis 7 Ringkohlenstoffatomen, $SiR^4_2$ oder $SnR^4_2$ ist, und $R^4$ $C_1$–$C_{12}$-Alkyl, $C_5$–$C_{12}$-Cycloalkyl, $C_6$–$C_{16}$-Aryl oder $C_7$–$C_{16}$-Aralkyl bedeutet,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch $-CF_2Z$ substituiert ist, worin Z für F oder unsubstituiertes oder substituiertes Alkyl steht, wobei der aromatische Ring weitere Substituenten enthalten kann, und

$R^3$ die Bedeutung von $R^2$ hat oder für Halogen, Pseudohalogen, -OH, Alkoxy, Alkylthio, Aryloxy, Arylthio, Acyloxy, Sekundäramino, Alkinyl, Phenylalkinyl, substituiertes Aryl, $-SiR^4_3$ oder $-SnR^4_3$ steht, wobei $R^4$ die zuvor angegebene Bedeutung hat.

Bei den Gruppen $R^1$ handelt es sich bevorzugt um gleiche Reste. Als Substituenten kommen für $R^1$ z. B. in Frage:

lineares oder verzweigtes Alkyl, Alkoxy und Alkenyl mit bevorzugt 1 bis 18, besonders 1 bis 12 und insbesondere 1 bis 6 C-Atomen, wie Methyl, Äthyl, Propyl, Isopropyl, n-Butyl, tert.-Butyl, Pentyl, Hexyl, Octyl, Decyl, Dodecyl, Tetradecyl, Hexadecyl, Octadecyl und entsprechende Alkenyl- und Alkoxygruppen;

Cycloalkyl und Cycloalkenyl mit bevorzugt 5 bis 8 Ringkohlenstoffatomen wie z. B. Cyclopentyl, Cyclohexyl, Cycloheptyl, Methylcyclopentyl und Methylcyclohexyl;

Aryl mit bevorzugt 6 bis 16 C-Atomen und Aralkyl mit bevorzugt 7 bis 16 C-Atomen wie z. B. Phenyl, Naphthyl, Pyridinyl, Benzyl und Phenyläthyl;

Nitril, Halogen, besonders F, Cl und Br sowie Amino, besonders tertiäres Amino, das lineare oder verzweigte Alkylgruppen mit 1 bis 12, besonders 1 bis 6 C-Atomen und insbesondere Methyl und Äthyl, Phenyl und Benzyl enthalten kann. Die Aminogruppen können auch quaternisiert sein, besonders mit linearen oder verzweigten Alkylhalogeniden mit vorzugsweise 1 bis 12 C-Atomen, besonders Methyl- oder Äthylhalogeniden;

lineares oder verzweigtes Aminoalkyl, besonders tertiäres Aminoalkyl, das auch quaternisiert sein kann, besonders mit Alkylhalogeniden. Die Alkylengruppe im Aminoalkyl kann linear oder verzweigt sein, und enthält bevorzugt 1 bis 12, insbesondere 1 bis 6 C-Atome und ist ganz besonders Methylen, das mit $C_1$–$C_{12}$-Alkyl substituiert sein kann.

Die Reste $R^1$ können bis zu 3, besonders aber 1, Substituenten enthalten. Insbesondere sind beide $R^1$ Cyclopentadienyl$^{\ominus}$ oder $C_1$–$C_4$-Alkylcyclopentadienyl$^{\ominus}$, besonders Methylcyclopentadienyl$^{\ominus}$.

X in Formel II enthält in seiner Bedeutung als Alkyliden bevorzugt 2 bis 6 C-Atome. Beispiele für Alkyliden und Cycloalkyliden sind Äthyliden, Propyliden, Butyliden, Hexyliden, Phenylmethylen, Diphenylmethylen, Cyclopentyliden und Cyclohexyliden. $R^4$ in der Gruppe X in seiner Bedeutung als Alkyl enthält bevorzugt 1 bis 6 C-Atome, und ist z. B. Methyl, Äthyl, Propyl, Butyl oder Hexyl, und ist in seiner Bedeutung als Cycloalkyl bevorzugt Cyclopentyl oder Cyclohexyl, in seiner Bedeutung als Aryl bevorzugt Phenyl und in seiner Bedeutung als Aralkyl bevorzugt Benzyl. Besonders bevorzugt ist X Methylen.

Der aromatische Rest ist bevorzugt durch nur eine $-CF_2Z$-Gruppe substituiert, besonders dann, wenn $R^3$ die gleiche Bedeutung wie $R^2$ hat. Z enthält als Alkyl bevorzugt 1 bis 12, besonders 1 bis 6 C-Atome. Das Alkyl kann insbesondere durch Halogen, bevorzugt Chlor und besonders Fluor, teilweise oder vollständig substituiert sein. Besonders bevorzugt ist die $-CF_2Z$-Gruppe Perfluoralkyl mit vorzugsweise bis 4 C-Atomen, und ist insbesondere die $CF_3$-Gruppe.

Bei $R^2$ in seiner Bedeutung als 6-gliedriger carbocyclischer aromatischer und $CF_2Z$-substituierter Ring kann es sich um Inden, Indan, Fluoren, Naphthalin und besonders Phenyl handeln. Beispiele sind: 4-(Trifluormethyl)inden-5-yl, 5,7-Di(trifluormethyl)indan-6-yl, 2-(Trifluormethyl)fluoren-3-yl, 3-(Trifluormethyl)naphth-2-yl und besonders 2-(Trifluormethyl)phen-1-yl.

$R^2$ als heterocyclischer aromatischer und 5-gliedriger Ring enthält bevorzugt ein Heteroatom

und als 6-gliedriger Ring bevorzugt 1 oder 2 Heteroatome. Beispiele für solche $-CF_2Z$-substituierte Ringe sind: 2-(Trifluormethyl)pyrr-3-yl, 2-(Trifluormethyl)fur-3-yl, 2-(Trifluormethyl)thiophen-3-yl, 2-(Trifluormethyl)pyrid-3-yl, 3-(Trifluormethyl)pyrid-4-yl, 4-(Trifluormethyl)pyrimid-5-yl.

Die Reste $R^2$ können teilweise oder vollständig duch weitere Gruppen substituiert sein. Geeignete Gruppen sind:

Lineares oder verzweigtes Alkyl oder Alkoxy mit bevorzugt 1 bis 18, insbesondere 1 bis 6 C-Atomen, z. B. Methyl, Äthyl, Propyl, Butyl, Pentyl, Hexyl und die entsprechenden Alkoxygruppen; besonders Methyl und Methoxy;

Cycloalkyl mit bevorzugt 5 oder 6 Ringkohlenstoffatomen, Aryl mit bevorzugt 6 bis 16 C-Atomen und Aralkyl mit bevorzugt 7 bis 16 C-Atomen wie z. B. Cyclopentyl, Cyclohexyl, Phenyl oder Benzyl;

Hydroxyl, Carboxyl, CN, Halogen wie F, Cl oder Br und Amino, besonders tertiäres Amino, das mit Alkylhalogeniden wie Methylchlorid, -bromid oder -jodid quaternisiert sein kann. Beispiele für Amino sind Methylamino, Äthylamino, Dimethylamino, Diäthylamino, Pyrrolidyl, Piperidyl, Piperazyl, Morpholyl, N-Methylpiperazyl;

Alkoxycarbonyl mit bevorzugt 1 bis 18, besonders 1 bis 6 C-Atomen in der Alkoxygruppe, Aminocarbonyl, dessen Aminogruppe mit ein oder zwei Alkylgruppen mit 1 bis 12 C-Atomen substituiert ist, oder Aminocarbonyl mit hetercyclischen Aminen wie Pyrrolidin, Piperidin, Piperazin, N-Methylpiperazin und Morpholin;

Aminoalkyl, besonders tertiäres Aminoalkyl mit bevorzugt $C_1$–$C_6$-Alkylgruppen, das mit Alkylhalogeniden quaternisiert sein kann. Bevorzugt ist Tertiäraminomethyl, das durch Alkyl mit 1 bis 12 C-Atomen substituiert sein kann. Beispiele sind Dimethylaminomethyl und Trimethylammoniummethyljodid.

Substituenten für $R^3$ als Phenylalkinyl, Aryl, Aryloxy und Arylthio sind z. B. Halogen wie F, Cl, Br, sekundär-Amino, Alkyl und Alkoxy mit 1 bis 6 C-Atomen, Carboxyl, -OH-und -CN.

$R^3$ in seiner Bedeutung als Halogen kann Jod und besonders Brom, Chlor und Fluor sein. $R^3$ in seiner Bedeutung als Pseudohalogenid ist bevorzugt Cyanat, Rhodanid, Azid und Cyanid.

$R^3$ als Alkoxy und Alkylthio kann linear oder verzweigt sein und 1 bis 12, besonders 1 bis 6 C-Atome enthalten. Bevorzugt sind Methoxy, Ethoxy, Methylthio und Ethylthio.

$R^3$ in seiner Bedeutung als Aryloxy bzw. Arylthio ist bevorzugt unsubstituiertes oder substituiertes Phenyloxy bzw. Phenylthio.

$R^3$ in seiner Bedeutung als Acyloxy ist bevorzugt der Rest einer aliphatischen, cycloaliphatischen oder aromatischen, vorzugsweise einbasischen Carbonsäure, die 1 bis 18 und besonders 1 bis 12 C-Atome enthalten kann. Beispiele für solche Säuren sind Ameisen-, Essig-, Monochloressig-, Trichloressig-, Trifluoressig-, Propion-, Butter-, Acryl-, Methacryl-, Benzoe-, Chlorbenzoe- und Phenylessigsäure.

$R^3$ in seiner Bedeutung als Sekundäramino entspricht bevorzugt der Formel $R^{10}R^{11}N$- worin $R^{10}$ und $R^{11}$ z. B. für $C_1$–$C_{12}$-Alkyl, unsubstituiertes oder mit Alkyl substituiertes Cyclopentyl, Cyclohexyl, Phenyl oder Benzyl, oder $R^{10}$ und $R^{11}$ zusammen unsubstituiertes oder mit Alkyl substituiertes und/oder gegebenenfalls mit -S-, -O- oder -N-Alkyl-unterbrochenes Tetra-, Penta- oder Hexamethylen stehen. Das Alkyl enthält vorzugsweise 1–4 C-Atome. Beispiele sind Methyl, Ethyl, n-Propyl, n-Butyl, i-Butyl, t-Butyl, Pentyl, Hexyl, Methylcyclohexyl, Methylphenyl, Methylbenzyl, $-(CH_2)_2-X'-(CH_2)_2-$ mit X' gleich direkte Bindung, $-CH_2-$, -O-, -S- und -N-Alkyl-, wobei das Alkyl 1 bis 4 C-Atome enthalten kann.

$R^3$ in seiner Bedeutung als Alkinyl entspricht vorzugsweise der Formel $C_xH_{2x+1}-C{\equiv}C-$, worin x für 0 oder eine Zahl von 1 bis 12 steht. Beispiele sind Ethinyl, Propargyl, Butinyl, Pentinyl und Hexinyl.

Beispiele für $R^3$ als substituiertes Phenylalkinyl sind (Methylphenyl)-, (Fluorphenyl)- und Chlorphenylalkinyl.

$R^3$ in seiner Bedeutung als substituiertes Aryl ist bevorzugt substituiertes Phenyl und besonders ein Rest der Formel

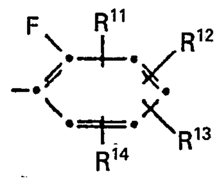

worin $R^{11}$ bis $R^{14}$ für ein Wasserstoffatom, Fluor, Chlor, Brom, $C_1$–$C_4$-Alkyl, Sekundäramino mit 2 bis 12 C-Atomen oder Tertiäraminomethyl mit 3 bis 18 C-Atomen, wobei die beiden Aminogruppen auch quaternisiert sein können, insbesondere mit $C_1$–$C_6$-Alkylhalogeniden, wie z. B. Alkyljodiden, stehen. Die Aminogruppen sind vorzugsweise nur einmal enthalten und in Parastellung zur freien Bindung gebunden. Besonders bevorzugt sind 2,6-Difluorphen-1-ylreste, insbesondere Pentafluorphenyl.

Der Rest $R^4$ ist bevorzugt $C_1$–$C_4$-Alkyl, Phenyl und Benzyl. Besonders ist $R^4$ Methyl oder Phenyl.

In einer bevorzugten Ausführungform hat $R^3$ die Bedeutung von $R^2$ und in einer anderen bevorzugten Ausführungsform steht $R^3$ für Halogen oder Pseudohalogen.

In einer bevorzugten Untergruppe entspricht $R^2$ der Formel III

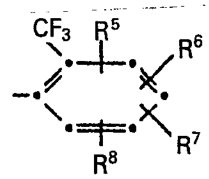

(III)

Besonders sind in Formel III $R^5$, $R^6$ und $R^7$ ein Wasserstoffatom und $R^8$ ein Wasserstoffatom oder in Orthostellung zur freien Bindung gebundenes Fluor.

In einer besonders bevorzugten Untergruppe

steht in Formel I $R^1$ für Cyclopentadienyl$^\ominus$ oder Methylcyclopentadienyl$^\ominus$, $R^2$ für

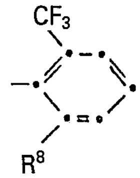

worin $R^8$ H oder F ist, und $R^3$ hat die zuvor angegebene Bedeutung und ist besonders Halogen oder Pseudohalogen, insbesondere F, Cl, Br, $N_3$, CN, NCO und NCS.

Die Herstellung der Titanocene der Formel I erfolgt nach bekannten oder analogen Verfahren. Man kann beispielsweise so vorgehen, dass man ein Titanocendihalogenid der Formel IV

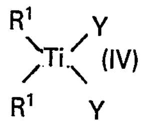

(IV)

worin Y für Halogen steht, zur Herstellung der Titanocene der Formel Ia

$$(R^1)_2Ti(IV)(R^2)_2 \text{ (Ia)}$$

mit 2 Mol $LiR^2$ umsetzt, oder zur Herstellung der Titanocene der Formel Ib

$$(R^1)_2Ti(IV)R^2Y \text{ (Ib)}$$

mit 1 Mol $LiR^2$ umsetzt, oder zur Herstellung der Titanocenen der Formel Ic

$$(R^1)_2Ti(IV)R^2R^9 \text{ (Ic)}$$

worin $R^9$ für Pseudohalogen, -OH, Alkoxy, Alkylthio, Aryloxy, Arylthio, Acyloxy, Sekundäramino, Alkinyl, Phenylalkinyl, substituiertes Aryl, $SiR^4_3$ oder $SnR^4_3$ steht, ein Titanocen der Formel Ib mit einer Alkaliverbindung der Formel $R^9Q$ umsetzt, worin Q Li, Na oder K bedeutet, und die Titanocene der Formel Ia, Ib und Ic in an sich bekannter Weise isoliert.

Die bekannten Verfahren sind z. B. in J. Organometal. Chem., 2 (1964), S. 206–212 und J. Organometal. Chem., 4 (1965), S. 446–445 beschrieben.

Die Ausgangsverbindungen der Formel IV, in denen Y besonders für Chlor steht, sind bekannt. Die Lithiumverbindungen $LiR^2$ und $LiR^3$ sind ebenfalls bekannt oder können z. B. nach analogen Verfahren durch die Umsetzung von $R^2$- bzw. $R^3$-Halogeniden, besonders den Bromiden, mit Butyllithium hergestellt werden.

Die Herstellung der Titanocene der Formel I erfolgt im allgemeinen in Gegenwart inerter Lösungsmittel wie z. B. Kohlenwasserstoffen oder Äthern bei Temperaturen unter –30 °C, z. B. –30 bis –100 °C, vorzugsweise –60 bis –90 °C und unter Schutzgasatmosphäre. In einer Ausführungsform des Verfahrens wird zunächst $LiR^2$ bzw. $LiR^3$ durch Umsetzung der entsprechenden Halogenide in Äther als Lösungsmittel mit Lithiumbutyl bei Temperaturen um –78 °C hergestellt. Zu der gekühlten Reaktionsmischung gibt man dann das entsprechende Titanocendihalogenid, entfernt die Kühlung und lässt auf Raumtemperatur erwärmen. Die Reaktionsmischung wird dann, gegebenenfalls nach Zugabe von Lösungsmitteln, filtriert und aus der Lösung durch Ausfällen oder Verdampfen des Lösungsmittels das erfindungsgemässe Titanocen isoliert.

Es handelt sich im allgemeinen um feste, kristalline und meist gefärbte Verbindungen, die sich durch eine hohe thermische Stabilität auszeichnen und sich erst um ihren Schmelzbereich zersetzen. Auch unter Lufteinwirkung sowie unter Einwirkung von Wasser wird keine Zersetzung beobachtet.

Die Verbindungen sind lagerstabil und können ohne Schutzgas gehandhabt werden. Sie eignen sich schon allein hervorragend als wirksame Fotoinitiatoren für die lichtinduzierte Polymerisation äthylenisch ungesättigter Verbindungen. Sie zeichnen sich hierbei durch eine sehr hohe Lichtempfindlichkeit und Wirksamkeit über einen grossen Wellenlängenbereich von ca. 200 nm (UV-Licht) bis etwa 600 nm aus. Die Lichtempfindlichkeit basiert auf der besonderen Struktur des Restes $R^2$. Ähnliche Titanocene, worin $R^2$ einen gegebenenfalls substituierten Phenylrest darstellt, weisen dagegen keine Lichtempfindlichkeit auf. Der Rest $R^3$ ist breit variierbar. So können für verschiedene Anwendungen massgeschneiderte Fotoinitiatoren hergestellt werden. Darüber hinaus kann die spektrale Empfindlichkeit (Farbe, Absorptionskoeffizienten) und die Löslichkeit beeinflusst werden.

Ein weiterer Gegenstand vorliegender Erfindung ist eine durch Strahlung polymerisierbare Zusammensetzung, enthaltend (a) mindestens eine nichtflüchtige, monomere, oligomere oder polymere Verbindung mit mindestens einer polymerisierbaren äthylenisch ungesättigten Doppelbindung und (b) mindestens ein Titanocen der Formel I als Fotoinitiator.

Die Zusatzmenge der erfindungsgemässen Metallocene richtet sich im wesentlichen nach wirtschaftlichen Gesichtspunkten, deren Löslichkeiten und nach der gewünschten Empfindlichkeit. Im allgemeinen werden 0,01 bis 25, vorzugsweise 0,1 bis 20 und besonders 1 bis 10 Gew.-% verwendet, bezogen auf die Komponente (a) und einen gegebenenfalls vorhandenen Binder (c).

Als Komponente (a) kommen solche äthylenisch ungesättigten monomeren, oligomeren und polymeren Verbindungen in Frage, die durch Fotopolymerisation zu höhermolekularen Produkten reagieren und hierbei ihre Löslichkeit verändern.

Besonders geeignet sind z. B. Ester und Amide von äthylenisch ungesättigten Carbonsäuren und Polyolen oder Polyepoxiden, und Polymere mit äthylenisch ungesättigten Gruppen in der Kette oder in Seitengruppen wie z. B. ungesättigte Polyester, Polyamide und Polyurethane und Copolymere hiervon, Polybutadien und Polybutadien-Copolymere, Polyisopren und Polyisopren-Copolymere, Polymere und Copolymere mit (Meth)Acrylgruppen, N-Maleinimidyl-alkyl-gruppen in Seitenketten, Additionsprodukte von Meth/Acrylsäuren an Di- oder Polyepoxide sowie Mischungen von ein oder mehr solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Ölsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenylen, Bisphenole wie Bisphenol-A, sowie Novolake und Resole. Beispiele für Polyepoxide sind solche auf der Basis der genannten Polyole, besonders der aromatischen Polyole und Epichlorhydrin. Ferner sind auch Polymere oder Copolymere mit Hydroxylgruppen in der Polymerkette oder in Seitengruppen, wie z.B. Polyvinylalkohol und Copolymere oder Polymethacrylsäurehydroxyalkylester oder Copolymere, als Alkohol geeignet. Weitere geeignete Alkohole sind Oligoester mit Hydroxylendgruppen.

Eine bevorzugte Gruppe von Polyolen sind solche der Formel $R^{15}(OH)_n$, worin $R^{15}$ ein n-wertiger, vorzugsweise 2- bis 8-, besonders 2- bis 6-wertiger aliphatischer Rest mit 2 bis 30 C-Atomen, der durch Stickstoff-, Schwefel- und besonders Sauerstoffatome sowie Cycloalkylen unterbrochen sein kann, oder Cycloalkylen mit 5 oder 6 Ringkohlenstoffatomen ist.

Beispiele für Polyole sind Alkylendiole mit bevorzugt 2 bis 12 C-Atomen, wie Äthylenglykol, 1,2- oder 1,3-Propandiol, 1,2-, 1,3- oder 1,4-Butandiol, Pentandiol, Hexandiol, Octandiol, Dodecandiol, Diäthylenglykol, Triäthylenglykol, Polyäthylenglykole mit Molekulargewichten von bevorzugt 100 bis 1500, 1,3-Cyclopentandiol, 1,2-, 1,3- oder 1,4-Cyclohexandiol, 1,4-Dihydroxymethylcyclohexan, Glycerin, Tris-(β-hydroxyäthyl)amin, Trimethyloläthan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. veräthert oder mit anderen Carbonsäuren verestert sein können.

Beispiele für Ester sind:

Trimethylolpropantriacrylat, Trimethyloläthantriacrylat, Trimethylolpropantrimethacrylat, Trimethyloläthantrimethacrylat. Tetramethylenglykoldimethacrylat, Triäthylenglykoldimethacrylat, Tetraäthylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Äthylenglykoldimethacrylat, 1,3-Butandioldiacrylat, 1,3-Butandioldimethacrylat, 1,4-Butandioldiitaconat, Sorbittriacrylat, Sorbittetraacrylat, Sorbittetramethacrylat, Sorbitpentaacrylat, Sorbithexaacrylat, Pentaerythrit-modifiziert-triacrylat, einem Oligoesteracrylat, einem Oligoestermethacrylat, Glyzerindi- und -triacrylat, 1,4-Cyclohexandiacrylat, Bis-acrylate und Bismethacrylate von Polyäthylenglykol mit Molekulargewicht von 100 bis 1500, oder Gemischen davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Amingruppen, und 2 bis 30, besonders 2 bis 18 C-Atomen, geeignet. Beispiele für Amine sind Alkylendiamine mit bevorzugt 2 bis 22 C-Atomen wie Äthylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoäthyläther, Diäthylentriamin, Triäthylentetramin, Di-(β-aminopropoxy)äthan. Weitere geeignete Polyamine sind Polymere und Copolymere mit Aminogruppen in der Seitenkette und Oligoamide mit Aminoendgruppen.

Beispiele sind: Methylen-bis-acrylamid, 1,6-Hexamethylen-bis-acrylamid, Diäthylentriamin-trismethacrylamid, Bis(methacrylamidopropoxy)-äthan, β-Methacryl-amidoäthylmethacrylat, N[(β-hydroxyäthyloxy)-äthyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit äthylenisch ungesättigten Comonomeren, z.B. Styrol, eingesetzt werden. Die Polyester und Polyamide können sich auch von gesättigten Dicarbonsäuren und äthylenisch ungesättigten Diolen und Diaminen ableiten, besonders längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Polyolefine wie Äthylen, Propen, Buten, Hexen, (Meth)Acrylate, Acrylnitril, Styrol oder Vinylchlorid. Polymere mit (Meth)Acrylatgruppen in der Seitenkette sind ebenfalls bekannt. Es kann sich z.B. um Umsetzungsprodukte von Epoxidharzen auf Bisphenol-A- oder Novolakbasis mit (Meth)Acrylsäure handeln, um Homo- oder Copolymere des Polyvinylalkohols oder deren Hydroxyalkylderivaten, die mit (Meth)Acrylsäure verestert sind, oder um Homo- oder Copolymere von (Meth)Acrylaten, die mit Hydroxyalkyl(meth)acrylaten verestert sind.

Die fotopolymerisierbaren Verbindungen können alleine oder in beliebigen Mischungen eingesetzt werden. Vorteilhaft ist das Zumischen von Estern ungesättigter Cabonsäuren, besonders der (Meth)Acrylate von Polyolen. In einer anderen

Ausführungsform werden (Meth)Acrylate von Polyolen alleine oder in Gemischen verwendet.

Den erfindungsgemässen Zusammensetzungen können auch Binder (c) zugesetzt werden, was besonders zweckmässig ist, wenn es sich bei den fotopolymerisierbaren Verbindungen um flüssige oder viskose Substanzen handelt. Die Menge des Binders (c) kann z.B, 5–95, vorzugsweise 10–90 und besonders 50–90 Gew.-% betragen, bezogen auf die vorhandene Menge an Komponente (b) und Binder (c).

Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000–2 000 000, bevorzugt 10 000 bis 1 000 000. Beispiele sind: Homo- und copolymere Acrylate und Methacrylate, z.B. Copolymere aus Methylmethacrylat/Äthylacrylat/Methacrylsäure, Poly(methacrylsäurealkylester), Poly(acrylsäurealkylester), wobei Alkyl = $C_1$–$C_{20}$-Alkyl ist, Celluloseester und -äther wie Celluloseacetat, Celluloseacetatbutyrat, Methylcellulose, Äthylcellulose, Polyvinylbutyral, Polyvinylformal, cyclisierter Kautschuk, Polyäther wie Polyäthylenoxid, Polypropylenoxid, Polytetrahydrofuran; Polycarbonat, Polyurethan, chlorierte Polyolefine, Polyvinylchlorid, Copolymere aus Vinylchlorid/Vinylidenchlorid, Copolymere von Vinylidenchlorid mit Acrylonitril, Methylmethacrylat und Vinylacetat, Polyvinylacetat, Copoly(äthylen/vinylacetat), Polyamide und Polycaprolactame wie Polycaprolactam und Poly(hexamethylenadipamid), Polyester wie Poly(äthylenglykolterephthalat) und Poly(hexamethylenglykolsuccinat).

Die erfindungsgemässe Zusammensetzung kann weitere übliche Zusatzstoffe enthalten, wie z.B. Inhibitoren der thermischen Polymerisation, Pigmente, Farbstoffe, Füllstoffe, Haftvermittler, Netzmittel und Weichmacher. Ferner können die Zusammensetzungen zur Applikation in geeigneten Lösungsmitteln gelöst weden.

Die Lichtempfindlichkeit der erfindungsgemässen Zusammensetzung kann durch die Zugabe von Sensibilisatoren weiter erhöht werden. Die Menge kann der Menge der Verbindungen der Formel I entsprechen. Geeignete Sensibilisatoren sind beispielsweise mono- oder polycyclische Kohlenwasserstoff- oder Heteroaromaten, Phenone, besonders der Aceto- oder Benzophenone, Benzile, Stilbene, Polyacetylene, Xanthone und Thioxanthone, Anthracene, Phthalimide, besonders der Phthalimidthioäther und Dione mit benachbaten CO-Gruppen. Weitere Beispiele sind in S.L. Murov, Handbook of Photochemistry, M. Dekker Inc., New York, Seiten 27ff (1973) beschrieben. Bevorzugt sind substituierte Thioxanthone.

Die erfindungsgemässen Zusammensetzungen eignen sich hervorragend als Beschichtungsmittel für Substrate aller Art, z.B. Holz, Papier, Keramik, Kunststoffe wie Polyester und Celluloseacetatfilme und Metalle wie Kupfer und Aluminium, bei denen durch Fotopolymerisation eine Schutzschicht oder eine fotographische Abbildung aufgebracht werden soll. Ein weiterer Gegenstand vorliegender Erfindung sind die beschichteten Substrate und ein Verfahren zum Aufbringen fotografischer Abbildungen auf den Substraten.

Die Herstellung der beschichteten Substrate kann z.B. erfolgen, indem man eine Lösung oder Suspension der Zusammensetzung herstellt.

Die Wahl des Lösungsmittels und die Konzentration richtet sich hauptsächlich nach der Art der Zusammensetzung und nach dem Beschichtungsverfahren. Die Lösung oder Suspension wird mittels bekannten Beschichtungsverfahren auf ein Substrat gleichförmig aufgebracht, z.T. durch Tauchen, Rakelbeschichtung, Vorhanggiessverfahren, Aufpinseln, Sprayen und Reverse roll Beschichtung. Die Auftragsmenge (Schichtdicke) und Art des Substrates (Schichtträger) sind abhängig vom gewünschten Applikationsgebiet. Für die fotografische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für fotografische Materialien und Offsetdruckformen betragen ca. 0,5 bis ca. 10 µm; für gedruckte Schaltungen 1 bis ca. 100 µm.

Die Fotopolymerisation von (Meth)Acrylaten wird bekanntlich durch Luftsauerstoff gehemmt, besonders in dünnen Schichten. Dieser Effekt lässt sich mit bekannten üblichen Methoden wie z.B. Aufbringen einer Deckschicht aus Polyvinylalkohol oder Vorbelichten oder Vorkonditionieren unter Inertgas vermindern. Ferner kann man Verbindungen beigeben, die den Einfluss des Sauerstoffs zurückdrängen. Solche Verbindungen sind in der US-PS 3 479 185 und 4 414 312 beschrieben.

Nach dem Beschichten wird das Lösungsmittel durch Trocknen entfernt und es resultiert eine Schicht des lichtempfindlichen Polymers auf dem Träger. Nach der in üblicher Weise erfolgten bildmässigen Belichtung des Materials durch eine Fotomaske werden die unbelichteten Stellen des Polymers durch Herauslösen in einem Entwickler entfernt und das Polymerrelief, bestehend aus vernetztem erfindungsgemässem Polymer freigelegt. Die Art des Entwicklers kann wässriger oder organischer Natur sein, je nach Art und Zusammensetzung der fotopolymerisierbaren Schicht. Für carboxylgruppenhaltige Verbindungen und Binder sind z.B. wässrige Karbonatlösungen geeignet. Geeignete organische Entwickler sind z.B. chlorierte Kohlenwasserstoffe wie 1,1,1-Trichloräthan, Ketone wie Cyclohexanon, Ester wie Butylacetat und Acetoxymethoxyäthan, Alkohole wie Äthylcellosolve, Methylcellosolve und Butanol.

Die Lichtempfindlichkeit der erfindungsgemässen Materialien reicht vom UV-Gebiet (200 nm) bis ca. 600 nm und umspannt somit einen sehr breiten Bereich. Als Lichtquellen kommen daher eine grosse Anzahl der verschiedensten Typen zur Anwendung. Es sind sowohl Punktlichtquellen als auch flächenförmige Strahler (Lampenteppiche)

geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und fotografische Flutlichtlampen. Der Abstand zwischen Lampe und erfindungsgemässem Bildmaterial kann je nach Anwendungszweck und Lampentyp bzw. -stärke variieren, z. B. zwischen 2 cm bis 150 cm. Speziell geeignet sind Laserlichtquellen, z. B. Argonionenlaser oder Kryptonionenlaser mit starken Emissionslinien (Ar-Laser) bei 457, 476, 488, 514, 528 nm. Bei dieser Art Belichtung ist keine Fotomaske im Kontakt mit der Fotopolymerschicht mehr nötig; der gesteuerte Laser-Strahl schreibt direkt auf die Schicht. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithografischen Offsetdruckplatten oder Reliefdruckplatten sowie fotografische Bildaufzeichnungsmaterialien hergestellt werden.

Die wichtigsten Anwendungen sind die Verwendung als Ätzresist, Galvanoresist und Lötstopplack bei der Herstellung von gedruckten Schaltungen und Druckplatten, die Herstellung von Fotopolymerdruckplatten für den Offsetdruck, Buchdruck (Hochdruck), sowie beim Flexodruck und Siebdruck als Abdecklack und zur Hertstellung von fotografischen Bildaufzeichnungsmaterialien, z. B. gemäss DE-A 2 651 864 oder DE-A 2 202 360.

Die nachfolgenden Beispiele erläutern die Erfindung näher.

Beispiele 1–11

In einem 500 ml Dreihalsrundkolben werden unter Argon 50 ml Butyllithium (1,6 molare Lösung in Hexan = 80 mMol) und 150 ml Diäthyläther vorgelegt und auf –70 °C abgekühlt. Dann werden 16,9 g o-Brom-tri-fluormethylbenzol (=75 mMol) in 150 ml Diäthyläther innerhalb 1 Stunde zugetropft und 1 Stunde bei –70 °C nachgerührt. Anschliessend werden 17,5 g $Cp_2TiCl_2$ (= 70,5 mMol) zugegeben und das Reaktionsgemisch unter Lichtausschluss langsam innert 3 Stunden bis auf Raumtemperatur aufgewärmt, wobei eine orange Suspension entsteht. Zur Aufarbeitung wird bis zur Trockene am Rotationsverdampfer eingedampft, der hochviskose Rückstand in 150 ml $CH_2Cl_2$ aufgenommen, über Hyflo filtriert und wieder eingedampft. Zur Fällung des Produktes wird der Rückstand mit 300 ml n-Hexan verrührt. Es resultieren 22,2 g oranges, kristallines Produkt (= 88% der Theorie).

In analoger Weise wird in den Beispielen 2–8 vorgegangen. Reaktionsbedingungen und Resultate sind in den Tabellen 1 und 2 angegeben. Cp steht für Cyclopentadienyl$^{\ominus}$.

Beispiele 12–20

In einem 250 ml Rundkolben werden 9,7 g (0,025 Mol) des Produktes aus Beispiel 3 und 5,5 g Kaliumrhodanid in 125 ml Aceton 18 Stunden bei Raumtemperatur unter Lichtausschluss gerührt. Danach wird das ausgefallene Salz abfiltriert, das Lösungsmittel verdampft (Rotationsverdampfer) und der dunkelrote Rückstand aus 100 ml n-Hexan kristallisiert. Es resultieren 7,3 g (= 71%) kristallines Produkt.

Auf analoge Weise wird bei den Beispielen 13–20 vorgegangen. Reaktionsbedingungen und Resultate sind in Tabellen 1 und 2 angegeben.

Tabelle 1

| Ausgangsmaterialien/Reaktionsbedingungen | | | | | | |
|---|---|---|---|---|---|---|
| Beispiel | Ti-Verbindung | Lithiumbutyl in Hexan (1,6 m) | Fluoraromat | | Lösungsmittel | Temp. |
| 1 | 17,5 g $Cp_2TiCl_2$ | 50 ml | 16,9 g | 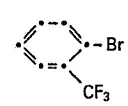 | 300 ml Äther | –70 °C |
| 2 | 18,5 g $Cp_2TiCl_2$ | 100 ml | 35 g | 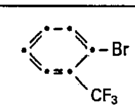 | 500 ml Äther | –70 °C |
| 3 | 78 g $(CH_3Cp)_2TiCl_2$ | 200 ml | 67,6 g | 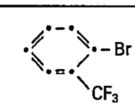 | 800 ml Äther | –70 °C |
| 4 | 20,6 g $Cp_2TiBr_2$ | 50 ml | 16,9 g | 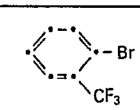 | 250 ml Äther | –70 °C |

Tabelle 1 (Forts.)

| Ausgangsmaterialien/Reaktionsbedingungen | | | | | |
|---|---|---|---|---|---|
| Beispiel | Ti-Verbindung | Lithiumbutyl in Hexan (1,6 m) | Fluoraromat | Lösungsmittel | Temp. |
| 5 | 36,7 g $(CH_3Cp)_2TiBr_2$ | 50 ml | 16,9 g 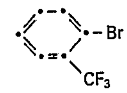 | 250 ml Äther | –70 °C |
| 6 | 15,2 g $Cp_2TiF_2$ | 50 ml | 16,9 g 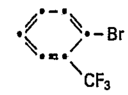 | 250 ml Äther | –70 °C |
| 7 | 17 g $(CH_3Cp)_2TiF_2$ | 50 ml | 16,9 g 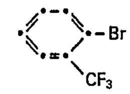 | 250 ml Äther | –70 °C |
| 8 | 15,2 g $Cp_2TiF_2$ | 50 ml | 12,5 g 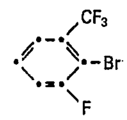 | 250 ml Äther<br>50 ml THF | –70 °C |
| 9 | 8,7 g $Cp_2TiCl_2$ | 25 ml | 9,4 g 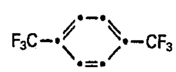 | 100 ml Äther<br>6 ml Tetramethyl-äthylendiamin | –70 °C |
| 10 | 9,8 g $(CH_3Cp)_2TiCl_2$ | 25 ml | 9,4 g 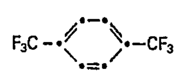 | 100 ml Äther<br>6 ml Tetramethyl-äthylendiamin | –70 °C |
| 11 | 3,6 g (4,5,6,7-Tetra-hydroindenyl)$_2$TiCl$_2$ | 8,1 ml | 2,7 g 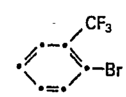 | 75 ml Äther | –70 °C |

| Ausgangsmaterialien / Reaktionsbedingungen | | | | | |
|---|---|---|---|---|---|
| Beispiel | Ti-Verbindung | Alkalisalz | Lösungsmittel | Temperatur | Reaktionszeit (h) |
| 12 | 9,7 g von Beispiel 3 | 2,75 g KSCN | 125 ml Aceton | Raumtemperatur | 18 |
| 13 | 9,7 g von Beispiel 3 | 2,75 g KOCN | 125 ml Aceton | Raumtemperatur | 48 |
| 14 | 9,7 g von Beispiel 3 | 1,75 g KCN | 125 ml Aceton | Raumtemperatur | 48 |
| 15 | 9,7 g von Beispiel 3 | 1,75 g $NaN_3$ | 125 ml Aceton | Raumtemperatur | 48 |
| 16 | 17,9 g von Beispiel 1 | 5,5 g KCSN | 250 ml Aceton | Raumtemperatur | 26 |
| 17 | 9,0 g von Beispiel 1 | 2,75 g KOCN | 125 ml Aceton | Rückfluss | 2 |
| 18 | 9,0 g von Beispiel 1 | 1,75 g $NaN_3$ | 125 ml Aceton | Raumtemperatur | 96 |
| 19 | 9,0 g von Beispiel 1 | 2,26 g $NaO(O)CCH_3$ | 250 ml Tetrahydrofuran | Raumtemperatur | 48 |
| 20 | 9,7 g von Beispiel 3 | 3,74 g $NaO(O)CCF_3$ | 250 ml Tetrahydrofuran | Raumtemperatur | 48 |

Tabelle 2

| Produkte und Eigenschaften | | | | | |
|---|---|---|---|---|---|
| Beispiele | Formel | Ausbeute (%) | Farbe | Zersetzungspunkt (°C) | Eigenschaften |
| 1 | 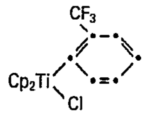 | 88 | orange | 157 | lichtempfindlich |
| 2 | 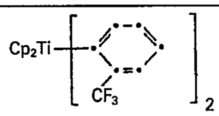 | 49 | gelb | 215 | lichtempfindlich |
| 3 | 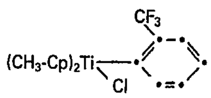 | 94 | orange | 138 | lichtempfindlich |
| 4 | 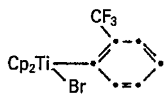 | 70 | orange | 136 | lichtempfindlich |
| 5 | 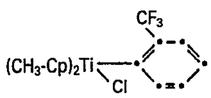 | 79 | orange | 118 | lichtempfindlich |
| 6 | 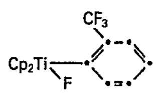 | 93 | gelb | 192 | lichtempfindlich |
| 7 | 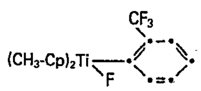 | 30 | gelb | 202 | lichtempfindlich |
| 8 | 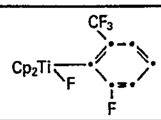 | 25 | orange | 224 | lichtempfindlich |
| 9 | 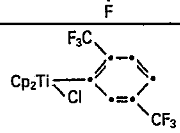 | 60 | orange | 190 | lichtempfindlich |
| 10 | 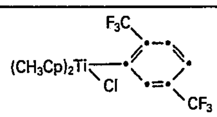 | 85 | orange | 135 | lichtempfindlich |
| 11 | 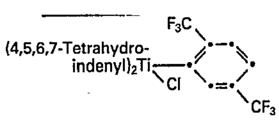 | 50 | orange | 125 | lichtempfindlich |
| 12 | 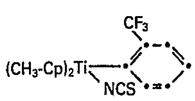 | 71 | dunkelorange | 158 | lichtempfindlich |
| 13 | 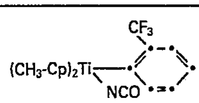 | 100 | orange | 148 | lichtempfindlich |
| 14 | 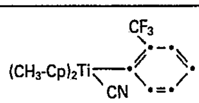 | 100 | orange | 140 | lichtempfindlich |

Tabelle 2 (Forts.)

| | Produkte und Eigenschaften | | | | |
|---|---|---|---|---|---|
| Beispiele | Formel | Ausbeute (%) | Farbe | Zersetzungspunkt (°C) | Eigenschaften |
| 15 | 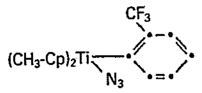 | 78 | orange | 158 | lichtempfindlich |
| 16 | 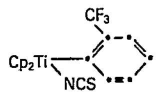 | 87 | orange | 140 | lichtempfindlich |
| 17 | 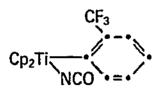 | 73 | orange-gelb | 140 | lichtempfindlich |
| 18 | 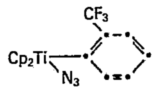 | 87 | orange | 160 | lichtempfindlich |
| 19 | 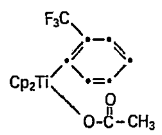 | 80 | orange | 150 | lichtempfindlich |
| 20 | 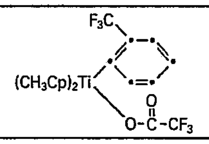 | 90 | orange | 135 | lichtempfindlich |

## Anwendungsbeispiele

### Beispiele 21–40

Alle Operationen werden unter Rotlicht ausgeführt.

Eine Beschichtungslösung der folgenden Zusammensetzung wird hergestellt:
6,96 g 1-Acetoxy-2-äthoxy-äthan
1,37 g Styrol/Maleinsäureanhydrid-Mischpolymerisat, Mw 10 000 (Säurezahl 190)
1,47 g Timethylolpropantriacrylat
0,20 g Polyäthylenglycol-200-diacrylat
0,05 g Initiator

Nach dem Mischen der Komponenten wird bis zur Lösung gerührt. Die Lösung beschichtet man mittels eines Drahtrakels mit 24 µm Nassfilmdicke auf eine vorbehandelte Aluminiumträgerfolie (Offsetplatten-Substrat) und trocknet 2 min bei 100 °C. Auf die trockene lichtempfindliche Schicht wird eine Polyvinylalkohol-Schutzschicht aus einer Lösung folgender Zusammensetzung aufgebracht:
30 g Polyvinylalkohol (Mowiol 4–88)
15 g Polyoxyäthylen-Lauryläther (Brij 35)
250 ml deionisiertes Wasser

Man beschichtet mit 12 µm Nassfilmdicke und trocknet 5 min bei 100 °C.

Das lichtempfindliche Material belichtet man in Kontakt mit einem Testnegativ, das einen Graukeil mit Dichteinkrementen von OD = 0,15 (Stauffer-Keil) aufweist. Als Belichtungsgerät dient ein Fotoresistilluminator (Oriel) mit einem 1 KW Hg/Xe-Brenner (43 mJ/cm$^2$ bei 365 nm).

Durch Eintauchen in eine Entwicklerlösung von folgender Zusammensetzung:
15,0 g Natrium-metasilikat·9$H_2O$
0,3 g Strontiumhydroxyd·8$H_2O$
3,0 g Polyethylenglycol 6000
0,5 g Lävulinsäure
1000,0 g deionisiertes Wasser
bei Raumtemperatur während 1 min wird das Reliefbild entwickelt, kurz mit Wasser gespült und mit Luft getrocknet. Die Bestimmung der Empfindlichkeit geschieht durch Zählen der abgebildeten Keilstufen. Die Resultate sind in nachfolgender Tabelle 3 dargestellt.

Tabelle 3

| Beispiel | Initiator Beispiel Nr. | Zahl der abgebildeten Keilstufen nach Sekunden Belichtungszeit | | | | |
|---|---|---|---|---|---|---|
| Nr. | | 1 | 2 | 4 | 8 | 16 |
| 21 | 1 | 1 | 5 | 7 | 9 | – |
| 22 | 2 | – | – | – | 5 | 7 |
| 23 | 3 | 3 | 5 | 7 | 9 | – |
| 24 | 4 | 4 | – | 6 | 8 | 10 |
| 25 | 5 | 5 | – | 6 | 8 | 10 |
| 26 | 6 | – | – | 4 | 6 | 8 |
| 27 | 7 | – | – | – | 3 | 5 |
| 28 | 8 | – | – | – | 2 | 4 |
| 29 | 9 | – | 3 | 6 | 8 | – |
| 30 | 10 | 2 | 5 | 7 | 10 | – |
| 31 | 11 | – | 4 | 6 | 9 | – |
| 32 | 12 | 4 | 6 | 8 | 10 | – |
| 33 | 13 | 2 | 4 | 6 | 8 | – |

Tabelle 3 (Forts.)

| Beispiel | Initiator Beispiel Nr. | Zahl der abgebildeten Keilstufen nach Sekunden Belichtungszeit | | | | |
|---|---|---|---|---|---|---|
| Nr. | | 1 | 2 | 4 | 8 | 16 |
| 34 | 14 | 3 | – | 6 | 8 | 10 |
| 35 | 15 | 3 | 5 | 7 | 9 | – |
| 36 | 16 | 4 | 6 | 8 | 10 | – |
| 37 | 17 | 1 | – | 5 | 7 | 9 |
| 38 | 18 | 1 | – | 5 | 7 | 9 |
| 39 | 19 | 1 | 4 | 5 | 8 | – |
| 40 | 20 | 4 | 6 | 9 | 11 | – |

Beispiele 41–50

Zusammensetzung der Beschichtungslösung:

6,96 g 1-Acetoxy-2-äthoxyethan
1,37 g Styrol/Maleinsäureanhydrid-Mischpolymer $\overline{Mw}$ 10 000 (Säurezahl 190)
1,47 g Trimethylolpropantriacrylat
0,20 g Polyäthylenglycol-200-diacrylat
0,05 g Initiator
0,05 g Sensibilisator

Die Durchführung ist analog Beispiel 21. Die Resultate sind in Tabelle 4 angegeben.

Tabelle 4

| Beispiel Nr. | Initiator Beispiel Nr. | Sensibilisator | Zahl der abgebildeten Keilstufe nach Sekunden Belichtungszeit 0,5 | 1 | 2 | 4 |
|---|---|---|---|---|---|---|
| 41 | 3 | 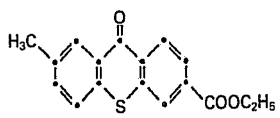 | 6 | 7 | 9 | – |
| 42 | 7 | | – | 5 | 7 | 9 |
| 43 | 17 | | 7 | 7 | 9 | – |
| 44 | 12 | 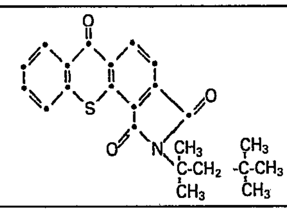 | – | 6 | 8 | 9 |
| 45 | 5 | | – | 7 | 8 | 10 |
| 46 | 5 | 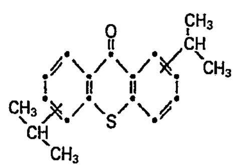 | 3 | 9 | – | – |
| 47 | 6 | | – | 6 | 8 | 10 |
| 48 | 8 | | – | 4 | 5 | 8 |
| 49 | 20 | | 7 | 9 | 11 | – |
| 50 | 5 | 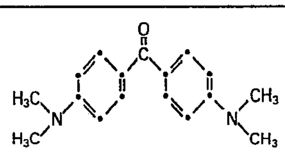 | – | 10 | – | – |

**Patentansprüche**

1. Titanocene der Formel I

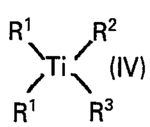

(I)

worin beide $R^1$ unabhängig voneinander unsubstituiertes oder substituiertes Cyclopentadienyl$^{\ominus}$, Indenyl$^{\ominus}$, 4,5,6,7-Tetrahydroindenyl$^{\ominus}$, oder beide $R^1$ zusammen für einen unsubstituierten oder substituierten Rest der Formel II

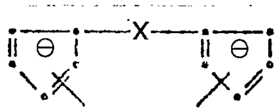

(II)

stehen, worin X $-(CH_2)_n-$ mit n = 1, 2 oder 3, Alkyliden mit 2 bis 12 C-Atomen, Cycloalkyliden mit 5 bis 7 Ringkohlenstoffatomen, $SiR_2^4$ oder $SnR_2^4$ ist und $R^4$ $C_1$–$C_{12}$-Alkyl, $C_5$–$C_{12}$-Cycloalkyl, $C_6$–$C_{16}$-Aryl oder $C_7$–$C_{16}$-Aralkyl bedeutet,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch $-CF_2Z$ substituiert ist, worin Z für F oder unsubstituiertes oder substituiertes Alkyl steht, wobei der aromatische Ring weitere Substituenten enthalten kann, und

$R^3$ die Bedeutung von $R^2$ hat oder für Halogen, Pseudohalogen, -OH, Alkoxy, Alkylthio, Aryloxy, Arylthio, Acyloxy, Sekundäramino, Alkinyl, Phenylalkinyl, substituiertes Aryl, $SiR_3^4$ oder $SnR_3^4$

steht, wobei $R^4$ die zuvor angegebene Bedeutung hat.

2. Titanocene gemäss Anspruch 1, worin $R^1$ mit Alkyl, Alkenyl, Cycloalkyl, Cycloalkenyl, Aryl, Aralkyl, Alkoxy, Nitril, Halogen oder Amino oder Aminoalkyl oder quaternisiertem Amino oder Aminoalkyl substituiert ist.

3. Titanocene gemäss Anspruch 1, worin $R^2$ mit Alkyl, Cycloalkyl, Aryl, Aralkyl, Hydroxyl, Alkoxy, Carboxyl, Alkoxycarbonyl, Aminocarbonyl, Halogen, CN oder Amino oder Aminoalkyl oder quaternisiertem Amino oder Aminoalkyl substituiert ist.

4. Titanocene gemäss Anspruch 1, dadurch gekennzeichnet, dass $R^1$ Cyclopentadienyl$^{\ominus}$ oder Methylcyclopentadienyl$^{\ominus}$ ist.

5. Titanocene gemäss Anspruch 1, dadurch gekennzeichnet, dass $R^2$ einem Rest der Formel III

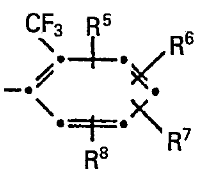

(III)

entspricht, worin $R^5$, $R^6$, $R^7$ und $R^8$ für ein Wasserstoffatom, Brom, Chlor oder besonders Fluor stehen.

6. Titanocene gemäss Anspruch 5, dadurch gekennzeichnet, dass $R^5$, $R^6$ und $R^7$ für ein Wasserstoffatom stehen, $R^8$ in Orthostellung zur freien Bindung gebunden ist und Fluor oder ein Wasserstoffatom bedeutet.

7. Titanocene gemäss Anspruch 1, dadurch gekennzeichnet, dass $R^4$ in Formel I die Bedeutung von $R^2$ hat oder für Halogen oder Pseudohalogen steht.

8. Titanocene gemäss Anspruch 1, dadurch gekennzeichnet, dass $R^1$ in Formel I für Cycopentadienyl$^{\ominus}$ oder Methylcyclopentadienyl$^{\ominus}$ steht, $R^2$

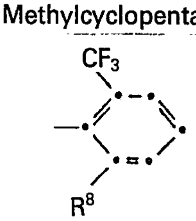

bedeutet und $R^3$ die in Anspruch 1 angegebene Bedeutung hat.

9. Titanocene gemäss Anspruch 8, dadurch gekennzeichnet, dass $R^3$ für Halogen oder Pseudohalogen steht.

10. Titanocene gemäss Anspruch 9, dadurch gekennzeichnet, dass $R^3$ für F, Cl, Br, $N_3$, CN, NCO oder NCS steht.

11. Durch Strahlung polymerisierbare Zusammensetzung, enthaltend (a) mindestens eine nichtflüchtige, monomere, oligomere oder polymere Verbindung mit mindestens einer polymerisierbaren äthylenisch ungesättigten Doppelbindung und (b) mindestens ein Titanocen der Formel I gemäss Anspruch 1 als Fotoinitiator.

12. Beschichtetes Substrat, das auf mindestens einer Oberfläche als Schicht eine Zusammensetzung gemäss Anspruch 11 enthält.

13. Verfahren zur fotografischen Herstellung von Reliefabbildungen, dadurch gekennzeichnet, dass man ein beschichtetes Substrat gemäss Anspruch 12 bildmässig belichtet und die unbelichteten Anteile danach mit einem Lösungsmittel entfernt.

14. Verwendung von Titanocenen der Formel I gemäss Anspruch 1 als Fotoinitiatoren für die Fotopolymerisation von äthylenisch ungesättigten Verbindungen.

**Claims**

1. A titanocene of the formula I

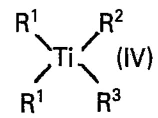

(I)

in which the two $R^1$ independently of one another are unsubstituted or substituted cyclopentadienyl$^{\ominus}$, indenyl$^{\ominus}$ or 4,5,6,7-tetrahydroindenyl$^{\ominus}$, or both $R^1$ together are an unsubstituted or substituted radical of the formula II

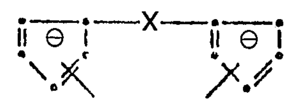

(II)

in which X is $-(CH_2)-_n$ with n = 1, 2 or 3, alkylidene having 2 to 12 C atoms, cycloalkylidene having 5 to 7 ring carbon atoms, $SiR^4_2$ or $SnR^4_2$, and $R^4$ is $C_1$–$C_{12}$alkyl, $C_5$–$C_{12}$cycloalkyl, $C_6$–$C_{16}$aryl or $C_7$–$C_{16}$aralkyl, $R^2$ is a 6-membered carbocyclic or 5-membered or 6-membered heterocyclic aromatic ring which is substituted in at least one of the two orthopositions relative to the metal-carbon bond by $-CF_2Z$, in which Z is F or unsubstituted or substituted alkyl, it being possible for the aromatic ring to contain further substituents, and $R^3$ is as defined for $R^2$ or is halogen, pseudohalogen, -OH, alkoxy, alkylthio, aryloxy, arylthio, acyloxy, secondary amino, alkynyl, phenylalkynyl, substituted aryl, $SiR^4_3$ or $SnR^4_3$, $R^4$ being as defined above.

2. A titanocene according to claim 1, wherein $R^1$ is substituted by alkyl, alkenyl, cycloalkyl, cycloalkenyl, aryl, aralkyl, alkoxy, cyano, halogen or amino or aminoalkyl or quaternized amino or aminoalkyl.

3. A titanocene according to claim 1, wherein $R^2$ is substituted by alkyl, cycloalkyl, aryl, aralkyl, hydroxyl, alkoxy, carboxyl, alkoxycarbonyl, aminocarbonyl, halogen, CN or amino or aminoalkyl or quaternized amino or aminoalkyl.

4. A titanocene according to claim 1, wherein $R^1$ is cyclopentadienyl$^{\ominus}$ or methylcyclopentadienyl$^{\ominus}$.

5. A titanocene according to claim 1, wherein $R^2$ is a radical of the formula III

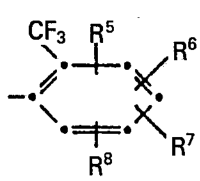

(III)

in which $R^5$, $R^6$, $R^7$ and $R^8$ are hydrogen atoms, bromine, chlorine or especially fluorine.

6. A titanocene according to claim 5, wherein $R^5$, $R^6$ and $R^7$ are hydrogen atoms, and $R^8$ is bonded in the ortho-position relative to the free bond and is fluorine or a hydrogen atom.

7. A titanocene according to claim 1, wherein $R^3$ in the formula I is as defined for $R^2$ or is halogen or pseudohalogen.

8. A titanocene according to claim 1, wherein $R^1$ in the formula I is cyclopentadienyl$^{\ominus}$ or methylcyclopentadienyl$^{\ominus}$, $R^2$ is

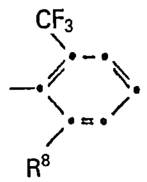

and $R^3$ is as defined in claim 1.

9. A titanocene according to claim 8, wherein $R^3$ is halogen or pseudohalogen.

10. A titanocene according to claim 9, wherein $R^3$ is F, Cl, Br, $N_3$, CN, NCO or NCS.

11. A composition which is polymerizable by radiation and contains (a) at least one non-volatile monomeric, oligomeric or polymeric compound having at least one polymerizable ethylenically unsaturated double bond and (b) at least one titanocene of the formula I according to claim 1 as a fotoinitiator.

12. A coated substrate which contains, on at least one surface, a layer of a composition according to claim 11.

13. A process for photografically producing relief images, which comprises exposing imagewise a coated substrate according to claim 12 and then removing the unexposed areas by means of a solvent.

14. The use of a titanocene of the formula I according to claim 1 as a photoinitiator for the photopolymerization of ethylenically unsaturated compounds.

**Revendications**

1. Titanocènes répondant à la formule I

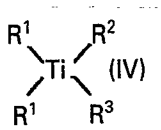

(I)

dans laquelle
les deux $R^1$ représentent chacun, indépendamment l'un de l'autre, un radical cyclopentadiényle$^{\ominus}$, indényle$^{\ominus}$ ou tétrahydro-4,5,6,7 indényle$^{\ominus}$, substitué ou non, ou forment ensemble un radical, substitué ou non, répondant à la formule II

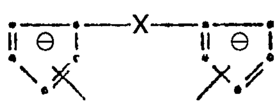

(II)

dans laquelle X représente un radical $-(CH_2)-_n$ dont l'indice n est égal à 1, à 2 ou à 3, un alkylidène contenant de 2 à 12 atomes de carbone, un cycloalkylidène contenant de 5 à 7 atomes de carbone dans son cycle, un radical $SiR^4_2$ ou $SnR^4_2$, le symbole $R^4$ désignant un alkyle en $C_1$–$C_{12}$, un cycloalkyle en $C_5$–$C_{12}$, un arye en $C_6$–$C_{16}$ ou un alkylaryle en $C_7$–$C_{16}$,
$R^2$ représente un noyau aromatique carbocyclique hexagonal ou hétérocyclique pentagonal ou hexagonal qui, en au moins l'une des deux positions ortho par rapport à la liaison métal-cabone, porte un substituant $-CF_2Z$ dans lequel Z représente F ou un alkyle substitué ou non, le noyau aromatique pouvant porter d'autres substituants, et
$R^3$ a la signification qui a été donnée pour $R^2$ ou représente un halogène, un pseudo-halogène, un radical -OH, alcoxy, alkylthio, aryloxy, arylthio ou acyloxy, un radical amino secondaire, un radical alcynyle ou phénylalcynyle, un aryle substitué, un radical $-SiR^4_3$ ou un radical $-SnR^4_3$, où $R^4$ a la signification qui a été donnée ci-dessus.

2. Titanocènes selon la revendication 1 dans lesquels $R^1$ porte, comme substituant, un alkyle, un alcényle, un cycloalkyle, un cycloalcényle, un aryle, un aralkyle, un alcoxy, un cyano, un halogène, un amino, un aminoalkyle, un amino quaternisé ou un aminoalkyle quaternisé.

3. Titanocènes selon la revendication 1 dans lesquels $R_2$ porte, comme substituant, un alkyle, un cycloalkyle, un aryle, un aralkyle, un hydroxy, un alcoxy, un carboxy, un alcoxycarbonyle, un aminocarbonyle, un halogène, un cyano, un amino, un amino-alkyle, un amino quaternisé ou un aminoalkyle quaternisé.

4. Titanocènes selon la revendication 1 dans lesquels $R^1$ est un radical cyclopentadiényle$^{\ominus}$ ou un radical méthyl-cyclopentadiényle$^{\ominus}$.

5. Titanocènes selon la revendication 1 dans lesquels $R^2$ est un radical III

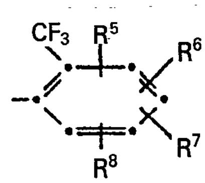

(III)

dans lequel $R^5$, $R^6$, $R^7$ et $R^8$ représentent chacun un atome d'hydrogène, de brome, de chlore ou, mieux, de fluor.

6. Titanocènes selon la revendication 5, caractérisés en ce que $R_5$, $R_6$ et $R^7$ représentent chacun un atome d'hydrogène et en ce que $R^8$ se trouve en position ortho par rapport à la liaison libre et représente un atome de fluor ou d'hydrogène.

7. Titanocènes selon la revendication 1, caractérisés en ce que $R^3$, dans la formule I, a la signification qui a été donnée pour $R^2$ ou représente un halogène ou un pseudo-halogène.

8. Titanocènes selon la revendication 1, caractérisés en ce que $R^1$, dans la formule I, représente un radical cyclopentadiényle$^{\ominus}$ ou méthyl-cyclopentadiényle$^{\ominus}$, $R^2$ représente un radical

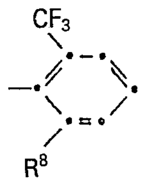

et $R^3$ a la signification qui lui a été donnée à la revendication 1.

9. Titanocènes selon la revendication 8, caractérisés en ce que $R^3$ représente un halogène ou un pseudo-halogène.

10. Titanocènes selon la revendication 9, caractérisés en ce que $R^3$ représente F, Cl, Br, $N_3$, CN, NCO ou NCS.

11. Composition polymérisable sous l'action d'un rayonnement, composition qui contient (a) au moins un composé monomère, oligomère ou polymère non volatil renfermant au moins une double liaison éthylénique polymérisable, et (b) au moins un titanocène de formule I selon la revendication 1 comme photo-amorceur.

12. Substrat revêtu qui comporte, sous la forme d'une couche sur au moins une surface, une composition selon la revendication 11.

13. Procédé pour réaliser photografiquement des images en relief, procédé caractérisé en ce qu'on expose à un rayonnement, conformément à une image, un substrat revêtu selon la revendication 12 et en ce qu'on élimine ensuite, au moyen d'un solvant, les parties qui n'ont pas été touchées par le rayonnement.

14. Application de titanocènes de formule I selon la revendication 1 comme photo-amorceurs pour la polymérisation de composés éthyléniques.